# FASCICULE DE BREVET EUROPEEN

(11) **EP 2 368 265 B1**
(45) Date de publication et mention de la délivrance du brevet: **21.08.2013**
(21) Numéro de dépôt: 09805753.2
(22) Date de dépôt: 18.12.2009
(51) Int. Cl.: H01L 21/762

(54) **STRUCTURE SEMICONDUCTRICE**
HALBLEITERSTRUKTUR
SEMICONDUCTOR STRUCTURE

(30) Priorité: 22.12.2008 FR 0858904
(43) Date de publication de la demande: 28.09.2011
(73) Titulaire: S'Tile, 86180 Buxerolles (FR)
(72) Inventeur: STRABONI, Alain, F-86180 Buxerolles (FR)
(74) Mandataire: de Beaumont, Michel
(86) Numéro de dépôt international: PCT/FR2009/052620
(87) Numéro de publication internationale: WO 2010/072956

(56) Documents cités:
- WO-A1-2004/093202
- FR-A- 2 804 245
- FR-A1- 2 934 186
- US-A1- 2007 128 742
- BERE E ET AL: "A NEW TECHNOLOGY FOR THE PRODUCTION OF SILICON SHEETS BY SINTERING OF SILICON POWDER BEDS" 17TH. E.C. PHOTOVOLTAIC SOLAR ENERGY CONFERENCE. MUNICH, GERMANY, OCT. 22 - 26, 2001; [PROCEEDINGS OF THE INTERNATIONAL PHOTOVOLTAIC SOLAR ENERGY CONFERENCE], MUNICH : WIP-RENEWABLE ENERGIES, DE, vol. CONF. 17, 22 octobre 2001 (2001-10-22), pages 1799-1801, XP001139810 ISBN: 978-3-936338-08-9
- SANTANA C J ET AL: "THE EFFECTS OF PROCESSING CONDITIONS ON THE DENSITY AND MICROSTRUCTURE OF HOT-PRESSED SILICON POWDER" JOURNAL OF MATERIALS SCIENCE, SPRINGER / BUSINESS MEDIA, DORDRECHT, NL, vol. 31, 1 janvier 1996 (1996-01-01), pages 4985-4990, XP000892023 ISSN: 0022-2461
- DATABASE INSPEC [en ligne] THE INSTITUTION OF ELECTRICAL ENGINEERS, STEVENAGE, GB Septembre 1991 CHIBANI A ET AL: 'Study of the texture in EPR ribbons of polycrystalline photovoltaic silicon' Database accession no. 4057524 & JOURNAL OF CRYSTAL GROWTH NETHERLANDS vol. 113, no. 3-4, pages 681 - 690 ISSN: 0022-0248

## Description

### Domaine de l'invention

La présente invention concerne principalement le domaine des matériaux semiconducteurs, et notamment les structures semiconductrices utilisables dans divers domaines, comme en électronique, microélectronique, optique, optoélectronique, et dans le domaine photovoltaïque.

### Exposé de l'art antérieur

Dans la demande de brevet français N° 03/04676, du même inventeur et ayant pour titre "Matériau semiconducteur obtenu par frittage", est décrit notamment un procédé de fabrication de plaquettes de silicium par frittage de poudres de silicium. Ces plaquettes sont propres notamment à réaliser des cellules photovoltaïques.

Dans la demande de brevet français N° 08/55149, du même inventeur et ayant pour titre "Fabrication et purification d'un solide semiconducteur", est décrit notamment un procédé de purification de plaquettes de silicium réalisées par frittage de poudres de silicium. Ces plaquettes purifiées sont propres, entre autres, à réaliser des cellules photovoltaïques.

FR2804245 (publié le 27-07-2010) décrit, un procédé de formation d'une couche mince monocristalline sur un substrat en Silicium.

Sous certains aspects, la présente invention peut être considérée comme une alternative ou une amélioration des procédés ou structures décrits dans les demandes de brevet citées ci-dessus. La présente invention présente aussi de nombreux objets. En particulier, la présente invention propose des alternatives et/ou des améliorations visant à palier tout ou partie des inconvénients de l'art antérieur.

### Résumé

Ainsi, un mode de réalisation de la présente invention prévoit une structure comprenant une première plaquette support réalisée par frittage de poudres de silicium et une deuxième couche réalisée en silicium monocristallin.

Dans un mode de réalisation de la présente invention, la structure comprend une couche formant barrière de diffusion entre la première plaquette support et la deuxième couche.

Dans un mode de réalisation de la présente invention, la structure comprend une couche formant isolant entre la première plaquette support et la deuxième couche.

Dans un mode de réalisation de la présente invention, la couche formant barrière de diffusion et/ou la couche formant isolant est une couche de silice, de nitrure de silicium et/ou de carbure de silicium.

Dans un mode de réalisation de la présente invention, la première plaquette support a une épaisseur supérieure à 50 micromètres et/ou la deuxième couche a une épaisseur comprise entre 1 et 50 micromètres.

Dans un mode de réalisation de la présente invention, la couche formant barrière de diffusion a une épaisseur inférieure à dix nanomètres et/ou la couche formant isolant a une épaisseur supérieure à dix nanomètres.

Dans un mode de réalisation de la présente invention, les canaux de porosité de la première plaquette support renferment un élément dopant ou une substance conductrice.

Dans un mode de réalisation de la présente invention, des trous traversent la première plaquette support et la couche formant isolant si celle-ci est présente.

La présente invention concerne aussi un procédé de réalisation d'une structure semiconductrice comportant les étapes suivantes :
a) une étape de frittage de poudres de silicium de façon à réaliser une plaquette support ; et
b) une étape de report d'une couche de silicium monocristallin sur la plaquette support.

Dans un mode de réalisation de la présente invention, le proced comprend en outre :
c) une étape consistant à placer une couche formant barrière de diffusion ou une couche isolante sur la plaquette support à l'issue de l'étape a), le report de la couche de silicium monocristallin prévu à l'étape b) ayant lieu sur l'ensemble formé par la plaquette support et la couche formant barrière de diffusion ou la couche isolante.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 représente un matériau selon la présente invention ;
les figures 2A, 2B, 2C et 2D illustrent un procédé selon la présente invention ;
la figure 3 représente un matériau selon la présente invention ; et
la figure 4 représente un matériau selon la présente invention.

### Description détaillée

Par souci de clarté, de mêmes éléments ont pu être désignés par de mêmes références aux différentes figures et, de plus, comme cela est habituel dans les domaines envisagés, les diverses figures ne sont pas tracées à l'échelle.

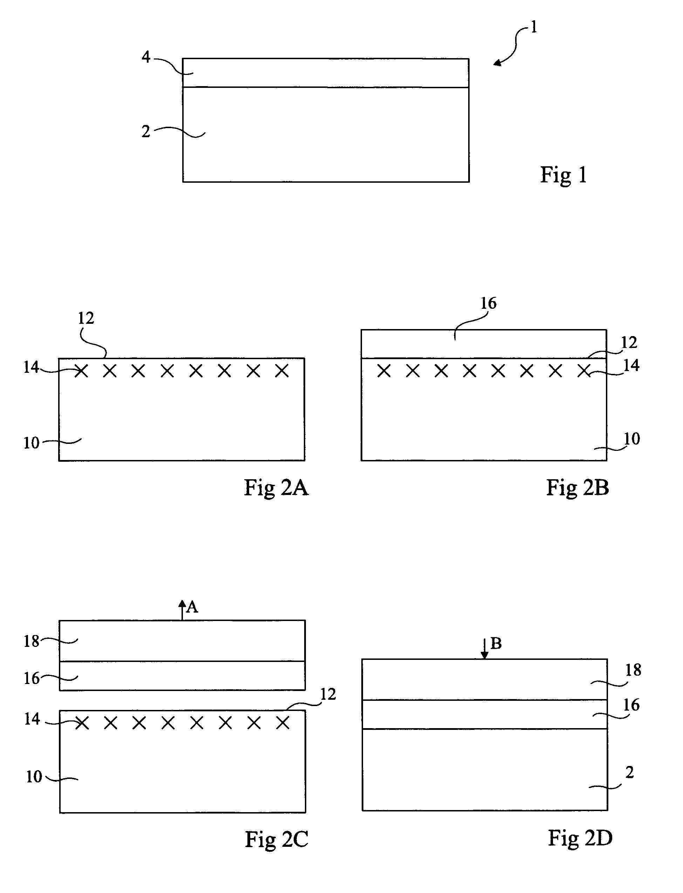

En figure 1, une structure 1 comprend une plaquette support 2 et une couche supérieure 4 reposant sur le support 2.

Le support 2 est formé d'une plaquette de silicium obtenue par frittage de poudres de silicium. Cette plaquette de silicium fritté est obtenue par compression et traitement thermique de poudres de silicium. Pour des détails concernant la réalisation de telles plaquettes, on pourra se reporter aux demandes de brevets de l'inventeur citées dans le préambule. Le support 2 est constitué de préférence de grains de silicium relativement petits et est poreux. L'épaisseur du support 2 peut varier dans une grande plage de valeurs. De préférence, l'épaisseur du support 2 est supérieure à 50 micromètres, par exemple comprise entre 200 et 500 micromètres. On notera que, du fait du faible coût des plaquettes en silicium fritté, l'épaisseur du support 2 peut être assez grande, par exemple de un à plusieurs millimètres, ce qui réalise des plaquettes solides sans augmenter sensiblement les coûts. Cela présente un avantage notable dans le domaine photovoltaïque, car les plaquettes sont très minces pour des questions de coût, ce qui conduit à des bris importants lors de la fabrication des cellules photovoltaïques.

La couche 4 est une couche de silicium monocristallin. L'épaisseur de la couche 4 peut être variable. L'épaisseur de la couche 4 est typiquement de l'ordre de 30 à 50 micromètres dans l'application photovoltaïque, et typiquement de l'ordre du micromètre pour d'autres applications, comme en microélectronique. La couche 4 est destinée à être la couche active de la structure 1. La couche 4 peut être obtenue par collage après décollement, comme cela va être décrit en relation avec les figures 2A à 2D.

En figure 2A, la référence 10 représente une plaque épaisse de silicium monocristallin. La plaque 10 a par exemple une épaisseur de l'ordre du millimètre et est destinée à fournir la couche 4 de la structure 1. Proche de la surface supérieure 12 de la plaque 10, se trouve une zone 14 de défauts. La zone de défauts 14 peut par exemple être obtenue par une attaque chimique qui rend la surface 12 poreuse tout en conservant la structure monocristalline de la plaque 10.

Ensuite, comme cela est illustré en figure 2B, on réalise une couche épitaxiée 16 de silicium monocristallin. La couche 16 est destinée à former la couche active 4 de la structure 1 et son épaisseur dépend de l'application envisagée.

En figure 2C, la couche épitaxiée 16 est enlevée de la plaque 10 par décollement. Pour ce faire, une lame 18, par exemple en plastique ou en verre, est collée sur la couche 16 et une force A est exercée sur la lame 18, perpendiculairement ou non à la surface 12. Du fait de la présence de la zone de défauts 14, la couche 16 se décolle de la plaque 10. D'autres techniques, comme un décollement par ultrasons ou jet d'eau sous pression peuvent être utilisées pour décoller la couche 16.

En figure 2D, l'ensemble formé par la couche 16 et la lame 18 est reporté sur le support 2 et une pression B peut être exercée sur la lame 18 pour favoriser le collage, qui a lieu par collage moléculaire. La surface supérieure du support 2 peut avoir été préparée, par exemple par décapage ou polissage, ainsi que la surface inférieure de la couche 16, pour favoriser le collage. Si cela est souhaité, un traitement thermique allié ou non à une compression peut être réalisé pour que le collage ait une meilleure tenue mécanique. Ensuite, la lame 18 est enlevée et l'ensemble formé par le support 2 et la couche 16 forme la structure 1 de la figure 1.

La structure 1 est ainsi formée d'une plaquette de silicium fritté 2 et d'une couche active de silicium monocristallin 4. Dans ou sur la couche active 4 peuvent être réalisés ensuite les différents dopages et/ou éléments de connexion pour réaliser un dispositif souhaité, comme un ou des circuits intégrés, un ou des composants électroniques, une ou des cellules photovoltaïques, etc.

Le fait que le support de la couche active soit en silicium fritté peut présenter des avantages significatifs.

Ainsi, le support et la couche active étant tous deux en silicium, ils présentent des propriétés physico-chimiques semblables. Il en résulte que les diverses étapes de réalisation du dispositif souhaité peuvent être réalisées sans qu'apparaissent certains problèmes dus par exemple à une mauvaise tenue en température du support, à des différences de dilatation entre support et couche active, etc.

En outre, la surface de la plaquette de silicium fritté est naturellement plus ou moins rugueuse et permet si besoin est un décollement ultérieur facile de la couche active. Cela permet par exemple, une fois que le dispositif souhaité a été réalisé, de décoller la couche active et de la transférer sur un autre support qui, du fait de ses propriétés physico-chimiques, n'aurait pas permis la réalisation du dispositif souhaité.

On notera aussi que, lors du frittage des poudres de silicium pour fabriquer le support 2, des dopants peuvent être mélangés aux poudres pour doper la plaquette. Par exemple, un fort dopage en bore rend le support 2 conducteur, ce qui va permettre de doter la structure 1 d'une électrode arrière.

Par ailleurs, on a vu dans les demandes de brevet de l'inventeur citées dans le préambule que le contrôle du frittage des poudres de silicium permet d'obtenir une plaquette frittée de porosité ouverte définie, dont les canaux de porosité sont interconnectés et débouchent sur l'extérieur. Les canaux de porosité peuvent être utilisés pour introduire des éléments dans la plaquette support. Par exemple, si la plaquette n'a pas déjà été dopée, des dopants peuvent être introduits en profondeur dans la structure de la plaquette. On peut aussi remplir les canaux de porosité d'une substance conductrice, par exemple à l'aide d'une pâte d'aluminium que l'on badigeonne sur la face inférieure de la couche 2 et que l'on fait fondre. Les canaux de porosité peuvent alors servir à établir une connexion entre le fond de la couche active et l'extérieur, sans que l'on soit obligé de prévoir une connexion sur la face supérieure de la couche active. Cela présente un intérêt notable dans le cas où le dispositif souhaité est une cellule photovoltaïque, car la surface supérieure de la couche active, exposée au soleil, s'en trouve agrandie et le rendement de la cellule est amélioré.

Parmi d'autres avantages présentés par un support en silicium fritté, on notera que la plaquette support peut être de forme quelconque et de petite ou de grande taille, selon les besoins. En effet, la forme et les dimensions souhaitées pour la plaquette peuvent être obtenues directement lors de la fabrication de la plaquette, en plaçant par exemple les poudres à fritter dans un moule approprié. Aussi, la plaquette de silicium fritté n'est pas forcément plane, comme cela apparaît dans les demandes de brevet de l'inventeur citées dans le préambule. La surface des plaquettes de silicium peut présenter des courbures et avoir par exemple la forme d'une tuile s'adaptant au toit d'un bâtiment existant. Cela présente un intérêt pour la réalisation de cellules photovoltaïques.

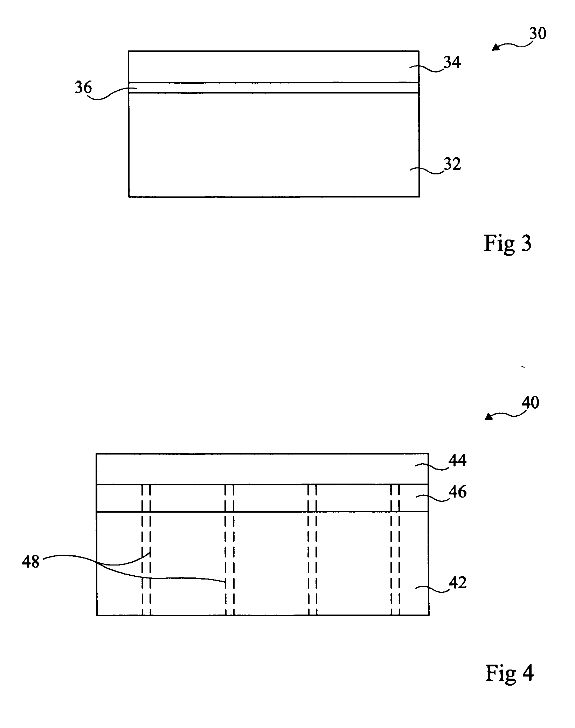

La figure 3 représente une autre structure selon la présente invention.

En figure 3, une structure 30 comporte plaquette support, une couche supérieure 34 et une couche intermédiaire 36. Le support 32 es32 est formé par une plaquette de silicium fritté, comme le support 2 de la figure 1, et son épaisseur est du même ordre. La couche intermédiaire 36 est une couche mince formant barrière de diffusion. La couche 36 peut par exemple être une couche de silice Si02, de nitrure de silice Si3N4, ou de carbure de silicium SiC. L'épaisseur de la couche 36 est très faible, typiquement inférieure à dix nanomètres. La couche supérieure 34 est une couche de silicium monocristallin, qui peut avoir été rapportée sur la couche 36 par le procédé des figures 2A à 2D. La couche 34 est destinée à être une couche active. Une épaisseur typique de la couche 34 est de l'ordre de un à quelques micromètres pour les applications microélectroniques, de 30 à 50 micromètres pour les applications photovoltaïques.

La présence de la couche mince 36 est avantageuse car la couche 36 joue le rôle de barrière de diffusion et peut faire barrage à des impuretés contenues dans la couche inférieure 32. Cela permet d'utiliser des poudres de silicium impures pour réaliser la plaquette support 32.

La structure 30 présente en outre les avantages de la structure 1 de la figure 1 (possibilité de plaquettes de grande dimension, de plaquettes non planes, avantages liés à un support en silicium, etc). Il est aussi possible d'utiliser les canaux de porosité de la plaquette support pour y introduire des dopants ou une substance conductrice assurant un contact électrique avec la partie inférieure de la couche active. En effet, bien que formée d'un matériau traditionnellement considéré comme isolant (silice, nitrure de silicium, carbure de silicium), la couche 36 est très mince et des mécanismes de conduction comme l'injection tunnel ou l'injection de charges par des défauts permettent à la couche 36 de laisser passer le courant électrique. On notera en outre que la présence de la couche mince 36 peut permettre d'améliorer le collage moléculaire de la couche active.

La figure 4 représente une autre structure selon la présente invention.

• En figure 4, une structure 40 comporte une partie inférieure formant support 42, une partie supérieure 44 et une partie intermédiaire 46. La couche inférieure 42 est formée par une plaquette de silicium fritté. La couche supérieure 44 est une couche de silicium monocristallin. La couche intermédiaire 46 est une couche épaisse isolante. La couche isolante 46 peut être constituée de silice SiO2, de nitrure de silicium Si3N4, de carbure de silicium SiC, etc.

L'épaisseur de la couche inférieure 42 peut être du même ordre que la couche inférieure 32 de la figure 3, c'est-à-dire supérieure à 50 micromètres, tout en pouvant être de plusieurs millimètres car son coût de fabrication n'est pas prohibitif. L'épaisseur de la couche supérieure active 44 dépend de la destination de la structure 40. Ainsi, pour une application photovoltaïque, une épaisseur de l'ordre de 30 à 50 micromètres convient pour la couche 44. L'épaisseur de la couche isolante 46, qui n'est pas critique, est typiquement de l'ordre de 100 nanomètres à quelques micromètres. On notera qu'il suffit que l'épaisseur de la couche 46 soit supérieure à 10 nanomètres pour que la couche 46 joue son rôle d'isolant.

La couche isolante 46 produit un barrage aux impuretés extrêmement efficace. Ainsi, des poudres de silicium très impures, par exemple des poudres de silicium métallurgique, peuvent être utilisées pour réaliser le support 42, sans que la couche active soit contaminée par les impuretés de la plaquette support.

On notera que, le support 42 étant électriquement isolé de la couche active 44, la structure 40 peut servir de structure "SOI" (silicium sur isolant) pour toutes les applications où des structures de type SOI sont utilisables. La structure 40 est néanmoins beaucoup moins chère que les structures de type SOI classiques, où la couche active repose sur un substrat de silicium monocristallin.

A priori, le support 42 étant électriquement isolé de la couche active 44, tous les contacts électriques doivent être prévus sur la face avant du dispositif, c'est-à-dire à la surface supérieure de la couche active. On notera cependant qu'il est aussi possible de prévoir des contacts électriques à la face arrière, comme dans le cas de la structure 30. Dans ce cas, une série de trous 48, en pointillés sur la figure 4, peuvent être prévus. Les trous 48 sont par exemple réalisés avec un rayon laser à partir de l'arrière de la structure et s'arrêtent après avoir traversé la couche isolante 46. Les trous 48 sont alors métallisés pour assurer un contact électrique. Le diamètre des trous 48 peut être de l'ordre de une à quelques dizaines de micromètres.

Des modes de réalisation particuliers de la présente invention ont été décrits. Diverses variantes et modifications apparaîtront à l'homme de l'art.

Notamment, les épaisseurs des différentes couches des structures décrites n'ont été données qu'à titre indicatif et peuvent être notablement modifiées.

De même, les dimensions ou formes des plaquettes n'ont été que peu mentionnées. Par exemple, pour réaliser des cellules photovoltaïques, on pourra utiliser des plaquettes carrées de 15 centimtiment de côté.

Aussi, les couches 36 et 46, représentées sur les figures entre la plaquette support et la couche active, peuvent entourer entièrement la plaquette support support, l'homme de l'art prévoyant les aménagements nécessaires si des contacts électriques doivent être prévus à l'arrière de la structure.

Aussi, les trous 48 de la figure 4 peuvent être aussi présents dans la plaquette support 2 de la figure 1 ou la plaquette support 32 de la figure 3. Ces trous seront même nécessaires si l'on souhaite accéder à la couche active par la face arrière de la structure et si la plaquette support a été réalisée sans laisser de porosité ouverte, c'est-à-dire si les canaux de porosité ne sont pas interconnectés et ne débouchent pas sur l'extérieur.

Bien entendu, la présente invention peut s'appliquer au domaine photovoltaïque, à tous les domaines où une structure de type SOI peut s'appliquer, ainsi qu'en optique, optoélectronique, électronique, microélectronique, etc. Par exemple la présente invention peut être utilisée pour réaliser des composants électroniques discrets, des puces électroniques, des microprocesseurs, des supports de puce électronique, en intégration 3D, etc.

## Revendications

1. Structure (1, 30, 40) comprenant une première plaquette support (2, 32, 42) en silicium fritté, et une deuxième couche (4, 34, 44) en silicium monocristallin.

2. Structure selon la revendication 1, comprenant une couche formant barrière de diffusion (36) entre la premiere plaquette support et la deuxième couche.

3. Structure selon la revendication 1, comprenant une couche formant isolant (46) entre la première plaquette support et la deuxième couche.

4. Structure selon la revendication 2 ou 3, dans laquelle la couche formant barrière de diffusion et/ou la couche formant isolant est une couche de silice, de nitrure de silicium et/ou de carbure de silicium.

5. Structure selon l'une quelconque des revendications 1 à 4, dans laquelle la première plaquette support a une épaisseur supérieure à 50 micromètres et/ou la deuxième couche a une épaisseur comprise entre un et 50 micromètres.

6. Structure selon l'une quelconque des revendications 2 à 5, dans laquelle la couche formant barrière de diffusion (36) a une épaisseur inférieure à dix nanomètres et/ou la couche formant isolant (46) a une épaisseur supérieure à dix nanomètres.

7. Structure selon l'une quelconque des revendications 1 à 6, dans laquelle la première plaquette support comporte des canaux de porosité interconnectés et débouchant sur l'extérieur.

8. Structure selon la revendication 7, dans laquelle les canaux de porosité renferment un élément dopant ou une substance conductrice.

9. Structure selon l'une quelconque des revendications 1 à 8, dans laquelle des trous (48) traversent la première plaquette support et la couche formant isolant si celle si est présente.

10. Structure selon l'une quelconque des revendications 1 à 9, dans laquelle le silicium de la première plaquette support est du silicium impur.

11. Procédé de réalisation d'une structure semiconductrice comportant les étapes suivantes :
a) une étape de frittage de poudres de silicium de façon à réaliser une plaquette support (2, 32, 42) ; et
b) une étape de report d'une couche de silicium monocristallin sur la plaquette support (2,32,42).

12. Procédé selon la revendication 11, comportant en outre :
c) une étape consistant à placer une couche formant barrière de diffusion (36) ou une couche isolante (46) sur la plaquette support à l'issue de l'étape a), le report de la couche de silicium monocristallin prévu à l'étape b) ayant lieu sur l'ensemble formé par la couche support et la couche formant barrière de diffusion ou la couche isolante.

13. Procédé selon la revendication 11 ou la revendication 12, dans lequel la plaquette support comporte des canaux de porosité interconnectés et débouchant sur l'extérieur et comprenant une étape consistant à faire entrer un élément dopant ou une substance conductrice dans les canaux de porosité de la plaquette support.

14. Procédé selon l'une quelconque des revendications 11 à 13, dans lequel les poudres de silicium sont de poudres de silicium impur.

15. Procédé selon l'une quelconque des revendications 11 à 14, comportant en outre une étape consistant à réaliser un dispositif sur la couche de silicium monocristallin, dite couche active, puis une étape consistant à décoller la couche active et une étape consistant à transférer la couche active sur un support autre que la plaquette support.

## Patentansprüche

1. Struktur (1, 30, 40), welche einen ersten Trägerwafer (2, 32, 42) aufweist, der aus gesintertem Silizium hergestellt ist, und eine zweite Schicht (4, 34, 44) aus einem monokristallinen Silizium.

2. Struktur nach Anspruch 1, welche eine Schicht aufweist, welche eine Diffusionsbarriere (36) zwischen dem ersten Trägerwafer und der zweiten Schicht bildet.

3. Struktur nach Anspruch 1, welche eine Schicht aufweist, die einen Isolator (46) zwischen dem ersten Trägerwafer und der zweiten Schicht bildet.

4. Struktur nach Anspruch 2 oder 3, wobei die Schicht eine Diffusionsbarriere bildet und/oder wobei die Schicht, die einen Isolator bildet, eine Siliziumoxyd-, Siliziumnitrid- und/oder Siliziumcarbid-Schicht ist.

5. Struktur nach einem der Ansprüche 1 bis 4, wobei der erste Trägerwafer eine Dicke von mehr als 50 Mikrometern hat und/oder wobei die zweite Schicht eine Dicke im Bereich zwischen einem und 50 Mikrometern hat.

6. Struktur nach einem der Ansprüche 2 bis 5, wobei die Schicht, welche eine Diffusionsbarriere (36) bildet, eine Dicke von weniger als zehn Nanometern hat, und/oder wobei die Schicht, welche einen Isolator (46) bildet, eine Dicke von mehr als zehn Nanometern hat.

7. Struktur nach einem der Ansprüche 1 bis 6, wobei der erste Trägerwafer Porositätskanäle aufweist, welche verbunden sind und sich nach außen öffnen.

8. Struktur nach Anspruch 7, wobei die Porositätskanäle ein Dotierungselement oder ein leitendes Material enthalten.

9. Struktur nach einem der Ansprüche 1 bis 8, wobei die Löcher (48) den ersten Trägerwafer und, falls vorhanden, die Schicht durchlaufen, welche einen Isolator bildet.

10. Struktur nach einem der Ansprüche 1 bis 9, wobei das Silizium des ersten Trägerwafers kein reines Silizium ist.

11. Verfahren zum Formen einer Halbleiterstruktur, welches Folgendes aufweist:
a) einen Schritt des Sinterns von Siliziumpulver, um einen Trägerwafer (2, 32, 42) zu formen; und
b) einen Schritt des Übertragens einer monokristallinen Siliziumschicht auf den Trägerwafer (2, 32, 42).

12. Verfahren nach Anspruch 11, welches weiter Folgendes aufweist:
c) einen Schritt des Anordnens einer Schicht, welche eine Diffusionsbarriere (36) bildet, oder einer Isolationsschicht (46) auf dem Trägerwafer am Ende des Schrittes a), wobei die Übertragung der monokristallinen Siliziumschicht, die im Schritt b) vorgesehen wird, auf der Anordnung auftritt, welche durch die Tragschicht und die Schicht gebildet wird, welche eine Diffusionsbarriere oder die Isolationsschicht bildet.

13. Verfahren nach Anspruch 11 oder 12, wobei der Trägerwafer Porositätskanäle aufweist, welche verbunden sind und sich nach außen öffnen, und wobei das Verfahren einen Schritt des Einleitens eines Dotierungsmaterials oder eines leitenden Materials in die Porositätskanäle des Trägerwafers aufweist.

14. Verfahren nach einem der Ansprüche 11 bis 13, wobei die Siliziumpulver Pulver aus nicht reinem Silizium sind.

15. Verfahren nach einem der Ansprüche 11 bis 14, welches weiter einen Schritt des Ausführens einer Vorrichtung auf der monokristallinen Siliziumschicht aufweist, welche aktive Schicht genannt wird, dann einen Schritt des Abziehens der aktiven Schicht, und einen Schritt der Übertragung der aktiven Schicht auf einen anderen Träger als den Trägerwafer.

## Claims

1. A structure (1, 30, 40) comprising a first support wafer (2, 32, 42) made of sintered silicon and a second layer (4, 34, 44) of single-crystal silicon.

2. The structure of claim 1, comprising a layer forming a diffusion barrier (36) between the first support wafer and the second layer.

3. The structure of claim 1, comprising a layer forming an insulator (46) between the first support wafer and the second layer.

4. The structure of claim 2 or 3, wherein the layer forming a diffusion barrier and/or the layer forming an insulator is a silica, silicon nitride, and/or silicon carbide layer.

5. The structure of any of claims 1 to 4, wherein the first support wafer has a thickness greater than 50 micrometers and/or the second layer has a thickness ranging between one and 50 micrometers.

6. The structure of any of claims 2 to 5, wherein the layer forming a diffusion barrier (36) has a thickness smaller than ten nanometers and/or the layer forming an insulator (46) has a thickness greater than ten nanometers.

7. The structure of any of claims 1 to 6, wherein the first support wafer comprises porosity channels that are interconnected and exit outwards.

8. The structure of claim 7, wherein the porosity channels contain a doping element or a conductive material.

9. The structure of any of claims 1 to 8, wherein holes (48) cross the first support wafer and the layer forming an insulator if present.

10. The structure of any of claims 1 to 9, wherein the silicon of the first support wafer is not pure silicon.

11. A method for forming a semiconductor structure comprising:
a) a silicon powder sintering step to form a support wafer (2, 32, 42); and
b) a step of transfer of a single-crystal silicon layer onto the support wafer (2, 32, 42).

12. The method of claim 11, further comprising:
c) a step of placing a layer forming a diffusion barrier (36) or an insulating layer (46) on the support wafer at the end of step a), the transfer of the single-crystal silicon layer provided at step b) occurring on the assembly formed by the support layer and the layer forming a diffusion barrier or the insulating layer.

13. The method of claim 11 or 12, wherein the support wafer comprises porosity channels that are interconnected and exit outwards, and comprising a step of introduction of a doping material or a conductive material in the porosity channels of the support wafer.

14. The method of any of claims 11 to 13, wherein the silicon powders are powders of not pure silicon.

15. The method of any of claims 11 to 14, further comprising a step of implementation of a device on the monocristalline silicon layer, called active layer, then a step of sticking off the active layer, and a step of transfer of the active layer on a support other than the support wafer.
